# EUROPEAN PATENT APPLICATION

(11) **EP 3 937 257 A1**
(43) Date of publication of application: **12.01.2022**
(21) Application number: 21184749.6
(22) Date of filing: 09.07.2021
(51) Int. Cl.: H01L 29/786, H01L 21/02

(54) **THIN-FILM TRANSISTORS HAVING HYBRID CRYSTALLINE SEMICONDUCTOR CHANNEL LAYER AND METHODS OF FORMING THE SAME**

(30) Priority: 10.07.2020 US 202063050347 P; 03.05.2021 US 202117306414
(71) Applicant: Taiwan Semiconductor Manufacturing Co., Ltd., Hsinchu 300-78 (TW)
(72) Inventor: LI, Hung Wei, Hsinchu (TW); MANFRINI, Mauricio, Hsinchu (TW); YEONG, Sai-Hooi, Hsinchu (TW); LIN, Yu-Ming, Hsinchu (TW)
(74) Representative: Valea AB

(57) **Abstract**

A transistor and method of making the same, the method including: forming a seed layer on a first dielectric layer, the seed layer including a crystalline metal oxide semiconductor material; depositing an amorphous silicon layer on the seed layer; annealing the amorphous silicon layer to form a single-crystal silicon (c-Si) layer; patterning the seed layer and the c-Si layer to form a hybrid channel layer; forming a gate dielectric layer on the hybrid channel layer; forming a gate electrode on the gate dielectric layer; and forming source and drain electrodes that respectively electrically contact a source region and a drain region of the hybrid channel layer.

## Description

### BACKGROUND

In the semiconductor industry, there is constant desire to increase the areal density of integrated circuits. To do so, individual transistors have become increasingly smaller. However, the rate at which individual transistors may be made smaller is slowing. Moving peripheral transistors from the front-end-of-line (FEOL) to the back-end-of line (BEOL) of fabrication may be advantageous because functionality may be added at the BEOL while valuable chip area may be made available in the FEOL. Thin film transistors (TFT) made of oxide semiconductors are an attractive option for BEOL integration because TFTs may be processed at low temperatures and thus, will not damage previously fabricated devices.

Various memory cell elements (e.g., magneto-resistive random-access memory (MRAM), resistive random-access memory (RRAM or ReRAM)) may utilize a transistor to select or energize the memory cell. However, CMOS transistors used as select transistor may limit the device density of memory cell elements as the size of CMOS transistors may be limiting.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1A is a vertical cross-sectional view of a first exemplary structure prior to formation of an array of TFTs according to an embodiment of the present disclosure.
FIG. 1B is a vertical cross-sectional view of the first exemplary structure during formation of the array of fin back gate field effect transistors according to an embodiment of the present disclosure.
FIG. 1C is a vertical cross-sectional view of the first exemplary structure after formation of upper-level metal interconnect structures according to an embodiment of the present disclosure.
FIGS. 2A-2J are vertical cross-sectional views illustrating a method of manufacturing a top-gate transistor including a hybrid crystalline oxide and single-crystal silicon (c-Si) semiconductor channel layer, according to various embodiments of the present disclosure.
FIGS. 3A-3H are vertical cross-sectional views illustrating a method of manufacturing a bottom-gate transistor including a hybrid crystalline oxide and single-crystal silicon (c-Si) semiconductor channel layer, according to various embodiments of the present disclosure.
FIGS. 4A-4C are vertical cross-sectional views illustrating a method of manufacturing a bottom-gate transistor including a hybrid crystalline oxide and single-crystal silicon (c-Si) semiconductor channel layer, according to various embodiments of the present disclosure.
FIG. 5 is a vertical cross-sectional view of a memory structure, according to various embodiments of the present disclosure.
FIG. 6 is a flow diagram of a method of forming a top-gate transistor, according to various embodiments of the present disclosure.
FIG. 7 is a flow diagram of a method of forming a bottom-gate transistor, according to various embodiments of the present disclosure.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. Unless explicitly stated otherwise, each element having the same reference numeral is presumed to have the same material composition and to have a thickness within a same thickness range.

The present disclosure is directed to semiconductor devices and fabrication methods, and specifically, to form crystalline silicon semiconductor devices during BEOL processes. In particular, the present disclosure provides method of forming crystalline semiconductor channel layers

Memory devices include a grid of independently functioning memory cells formed on a substrate. Memory devices may include volatile memory cells or nonvolatile (NV) memory cells. Emerging memory technologies seek to store more data at less cost than the expensive-to-build silicon chips used by popular consumer electronics. Such emerging memory devices may be used to replace existing memory technologies such as flash memory in near future. While existing resistive random-access memories have generally been adequate for their intended purposes, as device scaling-down continues, they have not been entirely satisfactory in all respects.

In some memory devices, metal-oxide-semiconductor field-effect transistors (MOSFETs) may be used to form CMOS logic gates that select various memory cells. MOSFETs may be formed by the controlled oxidation of a semiconductor material, which is typically silicon. However, size limitation of the CMOS technology may be the limiting factor in improving the size and memory cell density of memory devices.

TFTs are a type of MOSFET made by depositing thin films of an active semiconductor layer as well as the dielectric layer and metallic contacts over a supporting (but non-conducting) substrate. As such, TFTs may be formed during BEOL processes and may be used to control memory cells. TFTs may include semiconductor channel layers formed of amorphous silicon, metal oxide semiconductor materials, or low-temperature polycrystalline silicon (LTPS).

Since TFT are not formed by oxidizing a bulk single-crystal silicon substrate, the electrical performance of TFTs does not match that of MOSFETs formed by oxidizing a single-crystal silicon substrate. For example, amorphous silicon, metal oxide semiconductor, and LTPS channel TFTs have a substantially lower mobility than transistors including single-crystal channels. LTPS channel TFTs have a maximum mobility of about 300 cm²/Vs, but grain boundaries in the LTPS channel induce substantial amounts of current leakage. In addition, only n-type metal oxide semiconductor TFTs are currently commercially viable.

The various embodiments described herein provide methods of manufacturing improved TFTs, which may be used as selecting transistors in various devices. The improved TFTs of the various embodiments may include a channel layer formed via domain matching epitaxy processes that involve the use of a metal oxide semiconductor seed layer to form a single-crystal silicon channel. By promoting a crystalline structure in the seed layer, the formation of the single-crystal silicon channel may be promoted.

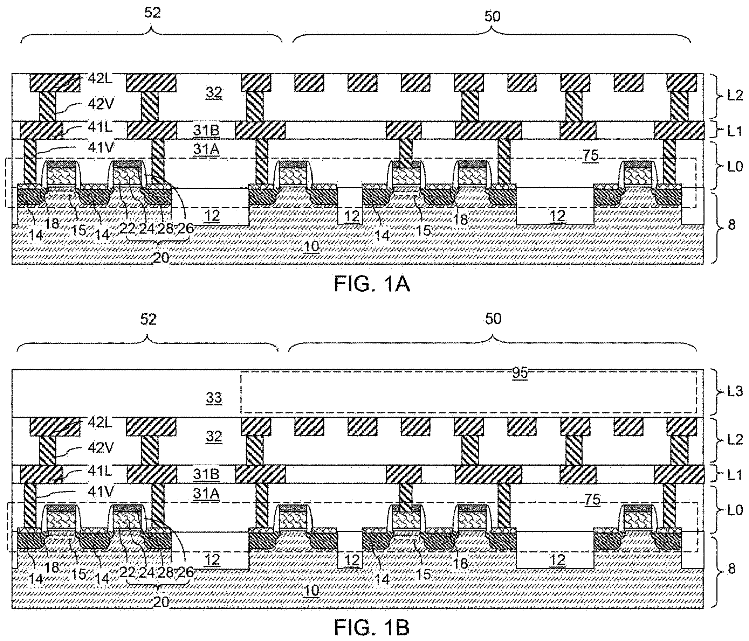

Referring to FIG. 1A, a first exemplary structure according to an embodiment of the present disclosure is illustrated prior to formation of an array of memory structures, according to various embodiments of the present disclosure. The first exemplary structure includes a substrate 8 that contains a semiconductor material layer 10. The substrate 8 may include a bulk semiconductor substrate such as a silicon substrate in which the semiconductor material layer continuously extends from a top surface of the substrate 8 to a bottom surface of the substrate 8, or a semiconductor-on-insulator layer including the semiconductor material layer 10 as a top semiconductor layer overlying a buried insulator layer (such as a silicon oxide layer). The exemplary structure may include various devices regions, which may include a memory array region 50 in which at least one array of non-volatile memory cells may be subsequently formed.

For example, the at least one array of non-volatile memory cells may include resistive random-access memory (RRAM or ReRAM), magnetic/magneto-resistive random-access memory (MRAM), ferroelectric random-access memory (FeRAM), and phase-change memory (PCM) devices. The exemplary structure may also include a peripheral logic region 52 in which electrical connections between each array of non-volatile memory cells and a peripheral circuit including field effect transistors may be subsequently formed. Areas of the memory array region 50 and the logic region 52 may be employed to form various elements of the peripheral circuit.

Semiconductor devices such as field effect transistors (FETs) may be formed on, and/or in, the semiconductor material layer 10 during a FEOL operation. For example, shallow trench isolation structures 12 may be formed in an upper portion of the semiconductor material layer 10 by forming shallow trenches and subsequently filling the shallow trenches with a dielectric material such as silicon oxide. Other suitable dielectric materials are within the contemplated scope of disclosure. Various doped wells (not expressly shown) may be formed in various regions of the upper portion of the semiconductor material layer 10 by performing masked ion implantation processes.

Gate structures 20 may be formed over the top surface of the substrate 8 by depositing and patterning a gate dielectric layer, a gate electrode layer, and a gate cap dielectric layer. Each gate structure 20 may include a vertical stack of a gate dielectric 22, a gate electrode 24, and a gate cap dielectric 28, which is herein referred to as a gate stack (22, 24, 28). Ion implantation processes may be performed to form extension implant regions, which may include source extension regions and drain extension regions. Dielectric gate spacers 26 may be formed around the gate stacks (22, 24, 28). Each assembly of a gate stack (22, 24, 28) and a dielectric gate spacer 26 constitutes a gate structure 20. Additional ion implantation processes may be performed that use the gate structures 20 as self-aligned implantation masks to form deep active regions. Such deep active regions may include deep source regions and deep drain regions. Upper portions of the deep active regions may overlap with portions of the extension implantation regions. Each combination of an extension implantation region and a deep active region may constitute an active region 14, which may be a source region or a drain region depending on electrical biasing. A semiconductor channel 15 may be formed underneath each gate stack (22, 24, 28) between a neighboring pair of active regions 14. Metal-semiconductor alloy regions 18 may be formed on the top surface of each active region 14. Field effect transistors may be formed on the semiconductor material layer 10. Each field effect transistor may include a gate structure 20, a semiconductor channel 15, a pair of active regions 14 (one of which functions as a source region and another of which functions as a drain region), and optional metal-semiconductor alloy regions 18. Complementary metal-oxide-semiconductor (CMOS) circuits 75 may be provided on the semiconductor material layer 10, which may include a periphery circuit for the array(s) of TFTs to be subsequently formed.

Various interconnect-level structures may be subsequently formed, which may be formed prior to formation of an array of selector field effect transistors and are herein referred to as lower interconnect-level structures (L0, L1, L2). In embodiments in which a two-dimensional array of TFTs may be subsequently formed over two levels of interconnect-level metal lines, the lower interconnect-level structures (L0, L1, L2) may include a contact-level structure L0, a first interconnect-level structure L1, and a second interconnect-level structure L2. The contact-level structure L0 may include a planarization dielectric layer 31A including a planarizable dielectric material such as silicon oxide and various contact via structures 41V contacting a respective one of the active regions 14 or the gate electrodes 24 and formed within the planarization dielectric layer 31A. The first interconnect-level structure L1 includes a first interconnect level dielectric layer 31B and first metal lines 41L formed within the first interconnect level dielectric layer 31B. The first interconnect level dielectric layer 31B is also referred to as a first line-level dielectric layer. The first metal lines 41L may contact a respective one of the contact via structures 41V. The second interconnect-level structure L2 includes a second interconnect level dielectric layer 32, which may include a stack of a first via-level dielectric material layer and a second line-level dielectric material layer or a line-and-via-level dielectric material layer. The second interconnect level dielectric layer 32 may have formed there within second interconnect-level metal interconnect structures (42V, 42L), which includes first metal via structures 42V and second metal lines 42L. Top surfaces of the second metal lines 42L may be coplanar with the top surface of the second interconnect level dielectric layer 32.

Referring to FIG. 1B, an array 95 of non-volatile memory cells and TFT selector devices may be formed in the memory array region 50 over the second interconnect-level structure L2. The details for the structure and the processing steps for the array 95 of non-volatile memory cells and TFT selector devices are subsequently described in detail below. A third interconnect level dielectric layer 33 may be formed during formation of the array 95 of non-volatile memory cells and TFT selector devices. The set of all structures formed at the level of the array 95 of non-volatile memory cells and TFT selector devices transistors is herein referred to as a third interconnect-level structure L3.

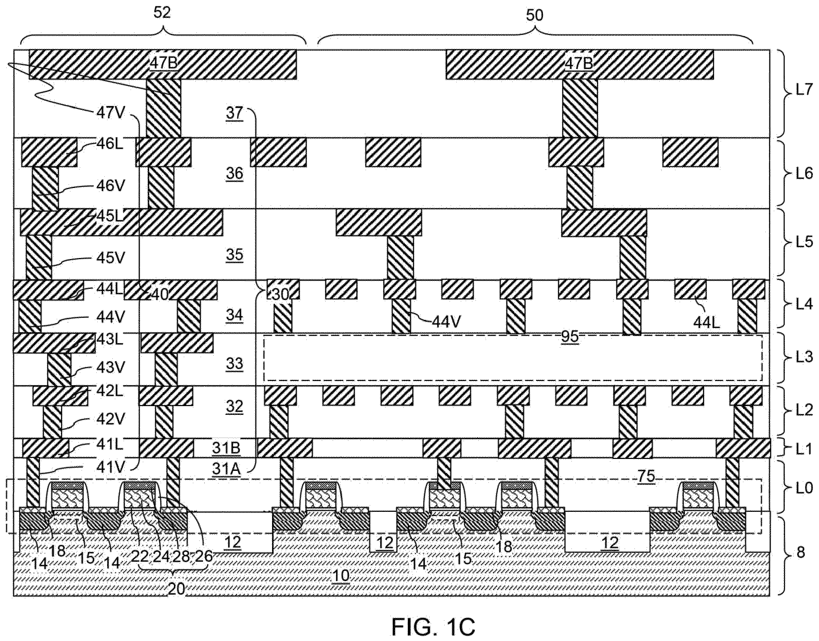

Referring to FIG. 1C, third interconnect-level metal interconnect structures (43V, 43L) may be formed in the third interconnect level dielectric layer 33. The third interconnect-level metal interconnect structures (43V, 43L) may include second metal via structures 43V and third metal lines 43L. Additional interconnect-level structures may be subsequently formed, which are herein referred to as upper interconnect-level structures (L4, L5, L6, L7). For example, the upper interconnect-level structures (L4, L5, L6, L7) may include a fourth interconnect-level structure L4, a fifth interconnect-level structure L5, a sixth interconnect-level structure L6, and a seventh interconnect-level structure L7. The fourth interconnect-level structure L4 may include a fourth interconnect level dielectric layer 34 having formed therein fourth interconnect-level metal interconnect structures (44V, 44L), which may include third metal via structures 44V and fourth metal lines 44L. The fifth interconnect-level structure L5 may include a fifth interconnect level dielectric layer 35 having formed therein fifth interconnect-level metal interconnect structures (45V, 45L), which may include fourth metal via structures 45V and fifth metal lines 45L. The sixth interconnect-level structure L6 may include a sixth interconnect level dielectric layer 36 having formed therein sixth interconnect-level metal interconnect structures (46V, 46L), which may include fifth metal via structures 46V and sixth metal lines 46L. The seventh interconnect-level structure L7 may include a seventh interconnect level dielectric layer 37 having formed therein sixth metal via structures 47V (which are seventh interconnect-level metal interconnect structures) and metal bonding pads 47B. The metal bonding pads 47B may be configured for solder bonding (which may employ C4 ball bonding or wire bonding), or may be configured for metal-to-metal bonding (such as copper-to-copper bonding).

Each interconnect level dielectric layer may be referred to as an interconnect level dielectric layer (ILD) layer 30. Each interconnect-level metal interconnect structures may be referred to as a metal interconnect structure 40. Each contiguous combination of a metal via structure and an overlying metal line located within a same interconnect-level structure (L2 - L7) may be formed sequentially as two distinct structures by employing two single damascene processes, or may be simultaneously formed as a unitary structure employing a dual damascene process. Each of the metal interconnect structure 40 may include a respective metallic liner (such as a layer of TiN, TaN, or WN having a thickness in a range from 2 nm to 20 nm) and a respective metallic fill material (such as W, Cu, Co, Mo, Ru, other elemental metals, or an alloy or a combination thereof). Other suitable materials for use as a metallic liner and metallic fill material are within the contemplated scope of disclosure. Various etch stop dielectric layers and dielectric capping layers may be inserted between vertically neighboring pairs of ILD layers 30, or may be incorporated into one or more of the ILD layers 30.

While the present disclosure is described employing an embodiment in which the array 95 of non-volatile memory cells and TFT selector devices may be formed as a component of a third interconnect-level structure L3, embodiments are expressly contemplated herein in which the array 95 of non-volatile memory cells and TFT selector devices may be formed as components of any other interconnect-level structure (e.g., L1-L7). Further, while the present disclosure is described using an embodiment in which a set of eight interconnect-level structures are formed, embodiments are expressly contemplated herein in which a different number of interconnect-level structures is used. In addition, embodiments are expressly contemplated herein in which two or more arrays 95 of non-volatile memory cells and TFT selector devices may be provided within multiple interconnect-level structures in the memory array region 50. While the present disclosure is described employing an embodiment in which an array 95 of non-volatile memory cells and TFT selector devices may be formed in a single interconnect-level structure, embodiments are expressly contemplated herein in which an array 95 of non-volatile memory cells and TFT selector devices may be formed over two vertically adjoining interconnect-level structures.

TFTs include source and drain electrodes that contact a channel and overlap with a gate electrode that is separated from the channel by a gate dielectric layer. However, such a configuration may result in a current flow path that extends through the bulk of the channel, thereby inducing channel length extension. In addition, parasitic resistance may occur where the source and/or drain electrodes contact the channel. Accordingly, TFTs may have degraded channel mobility, due to increased channel resistance and may suffer from increased threshold voltages. As such, there is a need for TFTs that provide for reduced channel resistance and threshold voltage. Various embodiments are disclosed herein provide for TFTs that include hybrid crystalline oxide and single-crystal silicon (c-Si) channel layers that have reduced channel resistance and threshold voltage, and/or improved channel mobility.

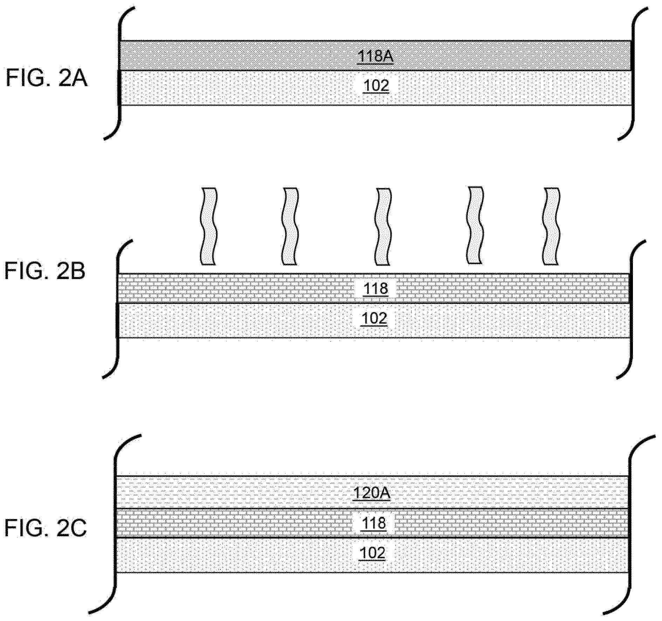

FIGS. 2A-2J are vertical cross-sectional views illustrating a method of manufacturing a top-gate (front-gate) transistor 200 including a hybrid crystalline metal oxide and c-Si semiconductor channel layer 125, according to various embodiments of the present disclosure.

Referring to FIG. 2A, a first dielectric layer 102 may be deposited on a device layer (not shown). For example, the first dielectric layer 102 may be deposited on the second interconnect-level structure L2 shown in FIGS. 1A-1C. In other words, the first dielectric layer 102 may be deposited on the second interconnect level dielectric layer 32.

The first dielectric layer 102 may be formed of any suitable dielectric material, such as silicon oxide (SiO₂), or the like, or a high-k dielectric material such as silicon nitride (SiN₄), hafnium oxide (HfO₂), hafnium silicon oxide (HfSiO), hafnium tantalum oxide (HfTaO), hafnium titanium oxide (HfTiO), hafnium zirconium oxide (Hf_{0.5}Zr_{0.5}O₂), tantalum oxide (Ta₂O₅), aluminum oxide (Al₂O₃), hafnium dioxide-alumina (HfO₂-Al₂O₃), zirconium oxide (ZrO₂), or the like. Other suitable dielectric materials may also be within the contemplated scope of disclosure.

The first dielectric layer 102 may be deposited using any suitable deposition process. Herein, suitable deposition processes may include chemical vapor deposition (CVD), physical vapor deposition (PVD), atomic layer deposition (ALD), high density plasma CVD (HDPCVD), metalorganic CVD (MOCVD), plasma enhanced CVD (PECVD), sputtering, laser ablation, or the like.

An amorphous seed layer 118A comprising a metal oxide semiconductor material may be deposited on the first dielectric layer 102. The amorphous seed layer 118A may be formed by depositing a metal oxide semiconductor material, using any suitable deposition process. For example, the metal oxide semiconductor material may include indium gallium zinc oxide (IGZO), indium tin oxide (ITO), InWO, InZnO, InSnO, GaOₓ, InOₓ, or the like. In some embodiments, the metal oxide semiconductor material may preferably be IGZO.

Referring to FIGS. 2A and 2B, a thermal annealing process may be performed to crystalize the amorphous seed layer 118A and form a seed layer 118 comprising crystalline metal oxide. Suitable annealing processes may include Excimer-laser annealing (ELA), flash lamp annealing (FLA), furnace annealing, or the like. However, other thermal annealing processes are within the scope of the present disclosure. In some embodiments, the seed layer 118 may be annealed at a temperature of at least 700 °C.

In the alternative, the metal oxide semiconductor material may be deposited on the first dielectric layer 102 at an elevated temperature, such that a crystalline seed layer 118 may be directly deposited on the first dielectric layer 102, without the need for a subsequent annealing process. For example, the metal oxide semiconductor material may be deposited at a temperature of greater than 100 °C, such as a temperature ranging from about 125 °C to about 400 °C.

Referring to FIG. 2C, an amorphous silicon layer 120A may be deposited on the crystalized seed layer 118. The amorphous silicon layer 120A may be deposited using any suitable deposition method, as described herein.

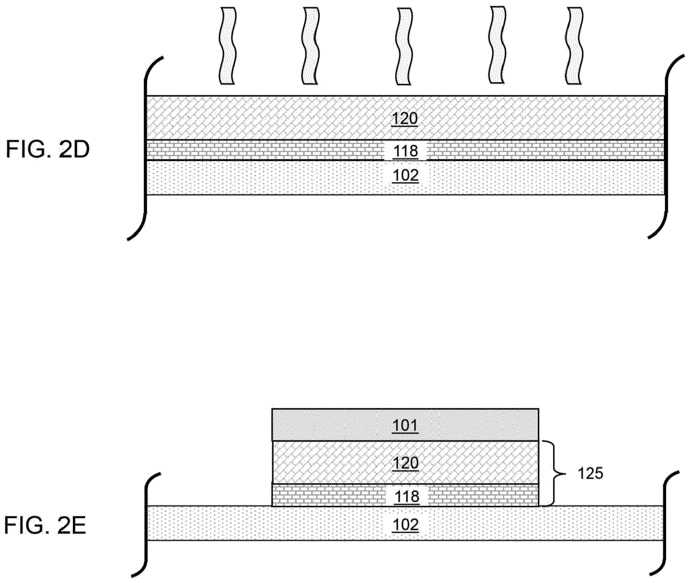

Referring to FIGS. 2C and 2D, a thermal annealing process may be performed to crystalize the amorphous silicon layer 120A and form a single-crystal silicon (c-Si) layer 120. In particular, the presence of the seed layer 118 may allow for the c-Si layer 120 to be crystallized at a lower temperature, as compared to instances in which the seed layer 118 was not present during an annealing process. For example, the annealing process may include a heating temperature of less than about 400 °C. Suitable annealing processes may include ELA, FLA, furnace annealing, or the like. However, other thermal annealing processes are within the scope of the present disclosure.

In various embodiments, the c-Si layer 120 may have a grain size that is larger than the grain size of a poly-crystalline silicon layer formed through LTPS. In addition, the c-Si layer 120 may be free of, or include only trace amounts of, silicon crystallites.

The seed layer 118 may have a lattice constant that differs from the lattice constant of the c-Si layer 120 by approximately an integer multiple. In other words, the c-Si layer 120 may be grown according to domain matching epitaxy (DME) methods, wherein epitaxial growth of hetero-thin films with very large lattice mismatch is possible by matching of domains where an integer multiples of major lattice planes match across the interface. For example, a lattice constant of the seed layer 118 may be within +/- 10% of an integer multiple of a lattice constant of the c-Si layer 120, or a lattice constant of the c-Si layer 120 may be within +/- 10% of an integer multiple of a lattice constant of the seed layer 118.

In some embodiments, the thickness of the seed layer 118 may range from about 0.5 nm to about 10 nm, such as from about 1 nm to about 5 nm. The thickness of the c-Si layer 120 may range from about 2 nm to about 50 nm, such as from about 5 nm to about 15 nm.

Referring to FIG. 2E, a photoresist layer 101 may be applied over the c-Si layer 120. The photoresist layer 101 may be applied over the c-Si layer 120 and lithographically patterned to form a channel layer pattern. An anisotropic etch process may be performed to etch unmasked portions of the c-Si layer 120 and the seed layer 118 to form a hybrid crystalline oxide and c-Si semiconductor channel layer 125. The anisotropic etch process may use any suitable etching process, such as a wet or dry etching process. The photoresist layer 101 may be subsequently removed, for example, by ashing.

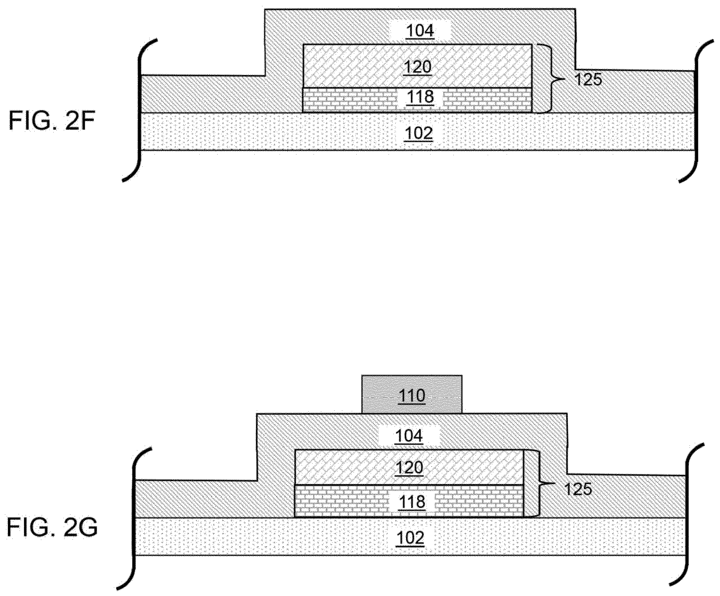

Referring to FIG. 2F, a gate dielectric layer 104 may be deposited on the first dielectric layer 102 and the channel layer 125. The gate dielectric layer 104 may be formed by depositing any suitable dielectric material such as silicon oxide (SiO₂), or the like, or a high-k dielectric material such as silicon nitride (SiN₄), hafnium oxide (HfO₂), hafnium silicon oxide (HfSiO), hafnium tantalum oxide (HfTaO), hafnium titanium oxide (HfTiO), hafnium zirconium oxide (Hf_{0.5}Zr_{0.5}O₂), tantalum oxide (Ta₂O₅), aluminum oxide (Al₂O₃), hafnium dioxide-alumina (HfO₂-Al₂O₃), zirconium oxide (ZrO₂), or the like. Other suitable dielectric materials may also be within the contemplated scope of disclosure. The gate dielectric layer 104 may be deposited using any suitable deposition method. The thickness of the gate dielectric layer 104 may be in a range from 1 nm to 12 nm, such as from 2 nm to 6 nm, although lesser and greater thicknesses may also be used.

Referring to FIG. 2G, a gate electrode 110 (e.g., word line) may be formed on the gate dielectric layer 104, overlapping with the channel layer 125. The gate electrode 110 may be formed of any suitable electrically conductive material, using any suitable method. For example, the electrically conductive material may include copper, aluminum, zirconium, titanium, titanium nitride, tungsten, tantalum, tantalum nitride, ruthenium, palladium, platinum, cobalt, nickel, iridium, alloys thereof, or the like.

The gate electrode 110 may be formed by depositing a photoresist material, patterning the photoresist material to form a patterned photoresist layer including a trench that exposes a portion of the gate dielectric layer 104, and depositing the electrically conductive material in the trench, using any suitable deposition process. The photoresist layer 101 may then be removed, for example, by ashing or a laser lift-off process. In the alternative, the gate electrode 110 may be formed by depositing a layer of the electrically conductive material, forming a patterned photoresist layer thereon, and then etching the electrically conductive material, using the photoresist layer as a mask, to form the gate electrode 110. The photoresist layer may subsequently be removed, for example, by ashing or a laser lift-off process.

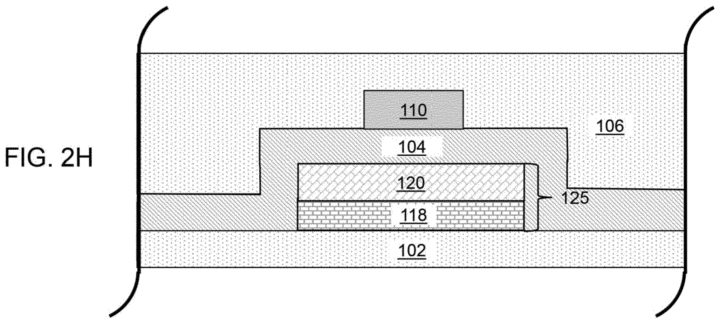

Referring to FIG. 2H, a second dielectric layer 106 may be formed on the gate electrode 110 and gate dielectric layer 104. The second dielectric layer 106 may be formed by depositing any suitable dielectric material, using any suitable deposition method. In some embodiments, the second dielectric layer 106 may be an interlayer dielectric layer (IDL).

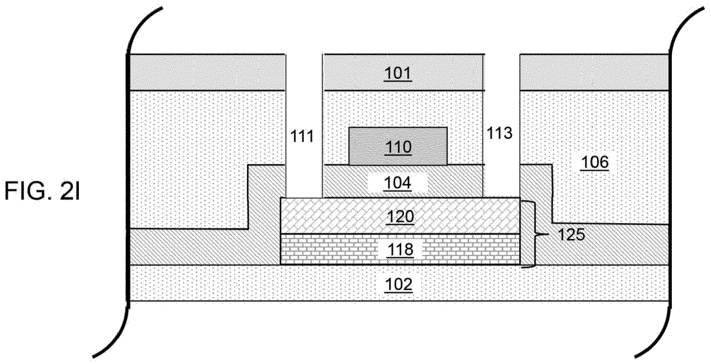

Referring to FIG. 2I, a photoresist layer 101 may be applied over the second dielectric layer 106. The photoresist layer 101 may be lithographically patterned to form two openings in the photo resist layer 101. An anisotropic etching process may be performed to form first via cavity 111 and second via cavity 113 that expose top surfaces of source and drain regions of the channel layer 125 (i.e., top surface of c-Si layer 120). The anisotropic etch may use any suitable etching process, such as a wet or dry etching process, to form the first via cavity 111 and second via cavity 113. The photoresist layer 101 may subsequently be removed, for example, by ashing.

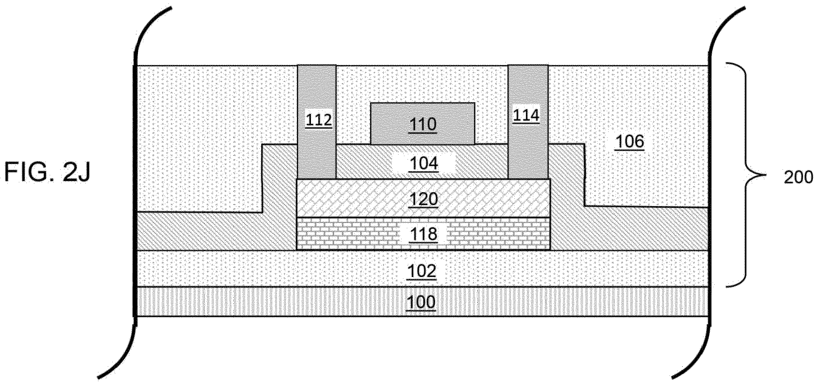

Referring to FIG. 2J, active region (source and drain) electrodes 112, 114 may be formed in the first via cavity 111 and second via cavity 113. In particular, an electrically conductive material may be deposited on the second dielectric layer 106 and in the first via cavity 111 and second via cavity 113. A planarization process may then be performed, such as CMP, in order to planarize the upper surfaces of the source and drain electrodes 112, 114, and the second dielectric layer 106, to remove excess metallic fill material and to form a co-planar top surface of the source and drain electrodes 112, 114 and the second dielectric layer 106. The top-gate transistor 200, including the hybrid crystalline oxide and c-Si semiconductor channel layer 125, may be formed upon the completion of the source and drain electrodes 112, 114.

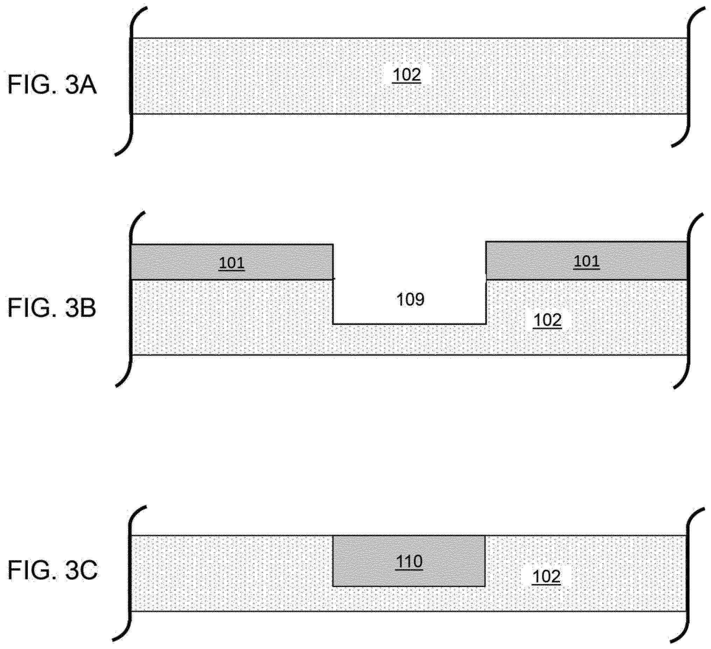

FIGS. 3A-3H are vertical cross-sectional views illustrating a method of manufacturing a bottom-gate transistor 300 including a hybrid crystalline oxide and single-crystal silicon (c-Si) semiconductor channel layer, according to various embodiments of the present disclosure. The transistor 300 includes elements similar to the transistor 200 of FIG. 2J, accordingly, only the differences there between will be described in detail.

Referring to FIG. 3A, a first dielectric layer 102 may be deposited on a device layer (not shown). For example, the first dielectric layer 102 may be deposited on the second interconnect-level structure L2 shown in FIGS. 1A-1C. In other words, the first dielectric layer 102 may be deposited on the second interconnect level dielectric layer 32. The first dielectric layer 102 may be formed of any suitable dielectric material such as silicon oxide (SiO₂), silicon nitride (SiN₄), or the like. Other suitable dielectric materials may also be within the contemplated scope of disclosure.

Referring to FIG. 3B, a patterned photoresist layer 101 may be formed on the first dielectric layer 102, and a gate trench 109 may formed by etching the first dielectric layer 102 using the photoresist layer 101 as a mask. The photoresist layer 101 may subsequently be removed, for example, by ashing.

Referring to FIGS. 3B and 3C, a gate electrode 110 (e.g., word line) may be formed in the gate trench 109. In particular, an electrically conductive material may be deposited over the first dielectric layer 102 and fill in gate trench 109. A planarization process, such as CMP, may then be performed to planarize upper surfaces of the first dielectric layer 102 and the gate electrode 110, and remove any excess electrically conductive material from the upper surface of the first dielectric layer 102. The gate electrode 110 may be formed of any suitable electrically conductive material, using any suitable deposition method as described herein. These suitable deposition methods may include chemical vapor deposition (CVD), physical vapor deposition (PVD), atomic layer deposition (ALD), high density plasma CVD (HDPCVD), metalorganic CVD (MOCVD), plasma enhanced CVD (PECVD), sputtering, laser ablation, or the like. The gate electrode 110 may be formed of copper, aluminum, zirconium, titanium, titanium nitride, tungsten, tantalum, tantalum nitride, ruthenium, palladium, platinum, cobalt, nickel, iridium, alloys thereof, or the like. Other suitable electrically conductive materials for formation of the gate electrode 110 may be within the contemplated scope of disclosure.

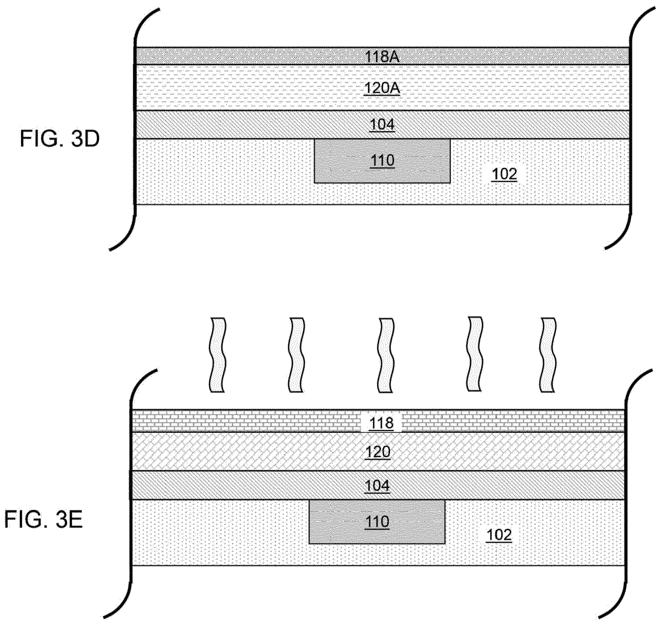

Referring to FIG. 3D, a gate dielectric layer 104 may be formed on the first dielectric layer and the gate electrode 110. The gate dielectric layer 104 may be formed by depositing any suitable dielectric material such as silicon oxide (SiO₂), or the like, or a high-k dielectric material such as silicon nitride (SiN₄), hafnium oxide (HfO₂), hafnium silicon oxide (HfSiO), hafnium tantalum oxide (HfTaO), hafnium titanium oxide (HfTiO), hafnium zirconium oxide (Hf_{0.5}Zr_{0.5}O₂), tantalum oxide (Ta₂O₅), aluminum oxide (Al₂O₃), hafnium dioxide-alumina (HfO₂-Al₂O₃), zirconium oxide (ZrO₂), or the like. The thickness of the gate dielectric layer 104 may be in a range from 1 nm to 12 nm, such as from 2 nm to 6 nm, although lesser and greater thicknesses may also be used.

An amorphous silicon layer 120A may be deposited on the gate dielectric layer 104, using any suitable deposition process. A thermal annealing process may be performed to reduce the hydrogen content of the amorphous silicon layer 120A. For example, the amorphous silicon layer 120A may be annealed at a temperature of about 400 °C, to remove hydrogen from the amorphous silicon layer 120A. The removal of the hydrogen may prevent ablation caused by sudden hydrogen eruption that may occur during crystallization of a hydrogenated amorphous silicon layer.

An amorphous seed layer 118A comprising a metal oxide semiconductor material may be deposited on the amorphous silicon layer 120A. The amorphous seed layer 118A may be formed by depositing a metal oxide semiconductor material, using any suitable deposition process. For example, the metal oxide semiconductor material may include InGaZnO (IGZO), indium tin oxide (ITO), InWO, InZnO, InSnO, GaOₓ, InOₓ, or the like. In some embodiments, the metal oxide semiconductor material may preferably be IGZO.

Referring to FIG. 3E, a thermal annealing process may be performed to form a c-Si layer 120 and a seed layer 118 comprising crystalline metal oxide semiconductor. In particular, during the annealing process, the amorphous seed layer 118A may be may be crystalized first to form the seed layer 118, and the seed layer 118 may promote the crystallization of the c-Si layer 120. In some embodiments, the seed layer 118 and the c-Si layer 120 may be crystalized in a single annealing step. In other embodiments, the seed layer 118 may be crystalized first, to facilitate the crystallization of the c-Si layer 120 and/or reduce an annealing temperature used to crystalize the c-Si layer 120.

For example, the annealing process may include a first heating step, wherein the amorphous seed layer 118A is selectively heated at temperature of greater than about 700 °C, to form a seed layer 118 comprising crystalline metal oxide semiconductor material. The annealing process may then include a second heating step, wherein the amorphous silicon layer 120A is heated at a lower temperature to form a c-Si layer 120. For example, the second heating step may include heating the amorphous silicon layer 120A at a temperature of about 650 °C, or less, such as about 600 °C. Suitable annealing processes may include ELA, FLA, furnace annealing, or the like. However, other thermal annealing processes are within the scope of the present disclosure.

Referring to FIGS. 3D and 3E, in the alternative, the metal oxide semiconductor material may be deposited on the amorphous silicon layer 120A at an elevated temperature, such that the crystalline seed layer 118 may be directly deposited on the amorphous silicon layer 120A. For example, the metal oxide semiconductor material may be deposited at a temperature of greater than 100 °C, such as a temperature ranging from about 125 °C to about 400 °C, to directly form the crystalline seed layer 118. The amorphous silicon layer 120A may then be annealed at a temperature of less than about 400 °C, as discussed above with regard to FIG. 3E.

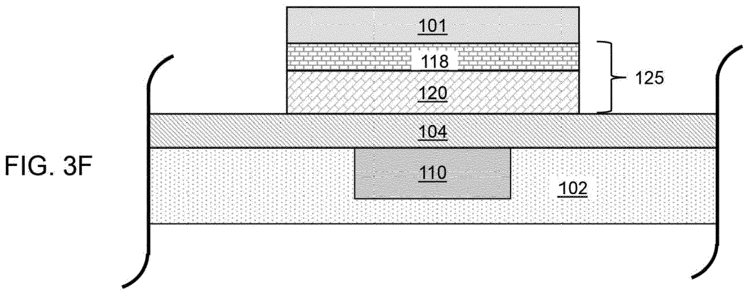

Referring to FIG. 3F, a patterned photoresist layer 101 may be formed on the crystalline seed layer 118. The seed layer 118 and the c-Si layer 120 may be etched, using the photoresist layer 101 as a mask, to form a hybrid crystalline oxide and c-Si semiconductor channel layer 125. Any suitable etching process may be used, such as wet or dry etching. The photoresist layer 101 may be subsequently removed, for example, by ashing.

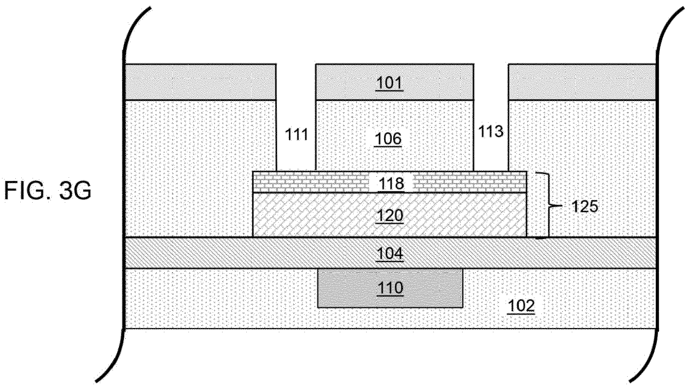

Referring to FIG. 3G, a second dielectric layer 106 may be deposited on the channel layer 125 and the gate dielectric layer 104. The second dielectric layer 106 may be formed by depositing any suitable dielectric material, using any suitable deposition process.

A photoresist layer 101 may be applied over the second dielectric layer 106. The photoresist layer 101 may be lithographically patterned to form two openings in the photo resist layer 101. An anisotropic etching process may be performed to form first and second via cavities 111, 113 that expose top surfaces of source and drain regions of the channel layer 125. The anisotropic etch may use any suitable etching process, such as a wet or dry etching process, to form the active region electrode via cavities 111, 113. The photoresist layer 101 may subsequently be removed, for example, by ashing.

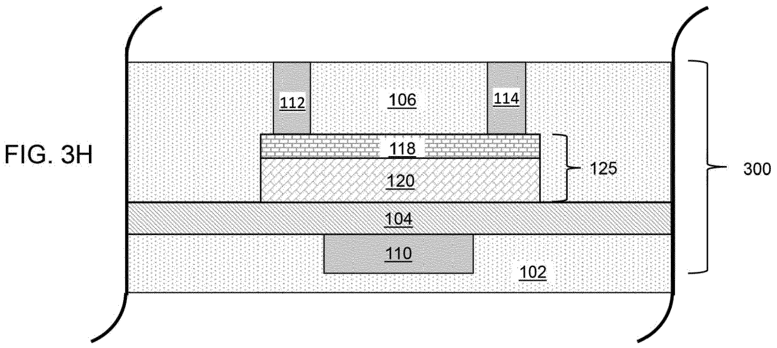

Referring to FIG. 3H, active region (source and drain) electrodes 112, 114 may be formed in the first via cavity 111 and second via cavity 113. In particular, an electrically conductive material may be deposited on the second dielectric layer 106 and in the first via cavity 111 and second via cavity 113. A planarization process may then be performed, such as CMP, in order to planarize the upper surfaces of the source and drain electrodes 112, 114, and the second dielectric layer 106, to remove excess metallic fill material and to form a co-planar top surface of the source and drain electrodes 112, 114 and the second dielectric layer 106. The bottom-gate (back-gate) transistor 300, including the hybrid crystalline oxide and c-Si semiconductor channel layer 125, may be formed upon the completion of the source and drain electrodes 112, 114.

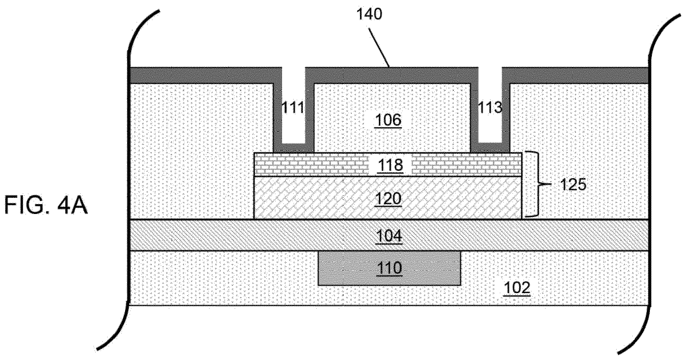

FIGS. 4A-4C are vertical cross-sectional views showing steps of a process for manufacturing a bottom-gate transistor 400 including a hybrid crystalline oxide and c-Si semiconductor channel layer 125, according to various embodiments of the present disclosure. The bottom-gate transistor 400 is similar to the bottom-gate transistor 300 of FIG. 3H. Accordingly, only differences there between will be discussed in detail.

Referring to FIG. 4A, a metal layer 140 is deposited on a semiconductor structure manufactured as shown in FIGS. 3A-3G. In particular, the metal layer 140 may be formed by depositing a metal on the second dielectric layer 106 and in the first via cavity 111 and second via cavity 113, using any suitable deposition process. The metal layer 140 may be deposited so as to coat side walls and the bottoms of the first via cavity 111 and second via cavity 113 to partially fill the first via cavity 111 and second via cavity 113. The metal layer 140 may be formed of a metal such as Al, Ti, Mo, Mg, Mn, or the like. Other suitable metal materials are within the contemplated scope of disclosure.

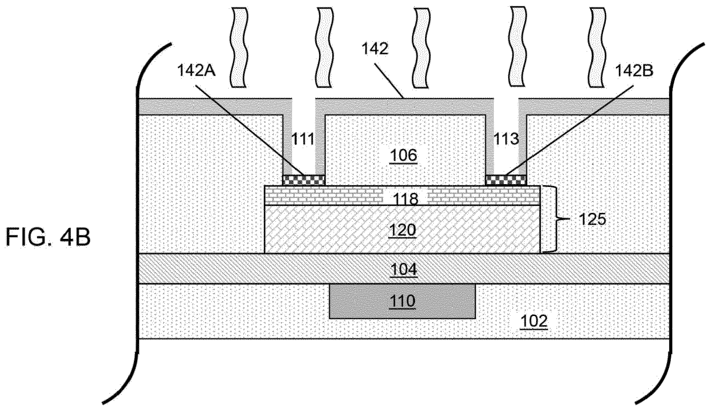

Referring to FIG. 4B, a thermal annealing process may be performed, such as furnace heating, to oxidize the metal layer 140 and form a metal oxide layer 142. Oxygen vacancies may be generated in portions of the metal oxide layer 142 that contact the channel layer 125, thereby generating first and second conductive (N+) regions 142A, 142B in the metal oxide layer 142.

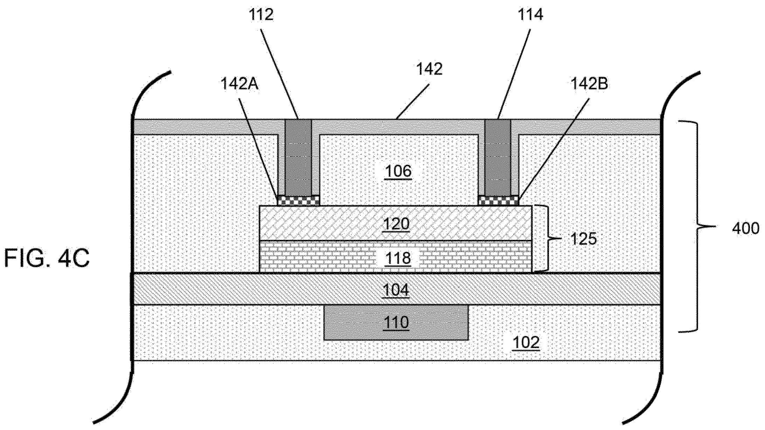

Referring to FIG. 4C, active region (source and drain) electrodes 112, 114 may be formed in the first via cavity 111 and second via cavity 113. In particular, an electrically conductive material may be deposited on the metal oxide layer 142, second dielectric layer 106, and in the first via cavity 111 and second via cavity 113. A planarization process may then be performed, such as CMP, in order to planarize the upper surfaces of the source and drain electrodes 112, 114, and the metal oxide layer 142, to remove excess metallic fill material and to form a co-planar top surface of the source and drain electrodes 112, 114 and the metal oxide layer 142. The source and drain electrodes 112, 114 may be electrically connected to the channel layer 125 by the conductive regions 142A, 142B. The bottom-gate transistor 400, including the hybrid crystalline oxide and c-Si semiconductor channel layer 125, may be formed upon the completion of the source and drain electrodes 112, 114.

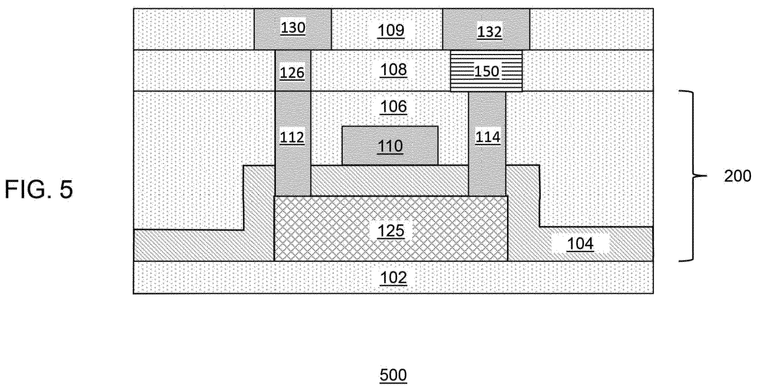

FIG. 5 is a vertical cross-sectional view of a memory structure 500, according to various embodiments of the present disclosure. Referring to FIG. 5, the memory structure 500 may include a top-gate transistor 200 covered by a second dielectric layer 106, a third dielectric layer 108 disposed on the second dielectric layer 106, and a fourth dielectric layer 109 disposed on the third dielectric layer 108, a source contact 126, a memory cell 150, a source line 130, and a bit line 132.

The source contact 126 and the memory cell 150 may be disposed in via holes formed in the third dielectric layer 108. The source line 130 and the bit line 132 may be disposed in trenches formed in the fourth dielectric layer 109. The source line 130 may be electrically connected to the source electrode by the source contact 126. The bit line 132 may electrically contact a top electrode of the memory cell 150, and a bottom electrode of the memory cell 150 may electrically contact the drain electrode 114.

In some embodiments, the memory structure 500 may include a bottom gate transistor, such as bottom-gate transistors 300, 400, shown in FIGS. 3H and 4C. The memory cell 150 may include any suitable type of memory cell, such as a metal-ferroelectric-metal capacitor, a magneto-resistive random-access memory (MRAM) cell, a resistive random-access memory (RRAM) cell, a ferroelectric random-access memory (FeRAM) cell, or a phase-change random-access memory (PCRAM cell).

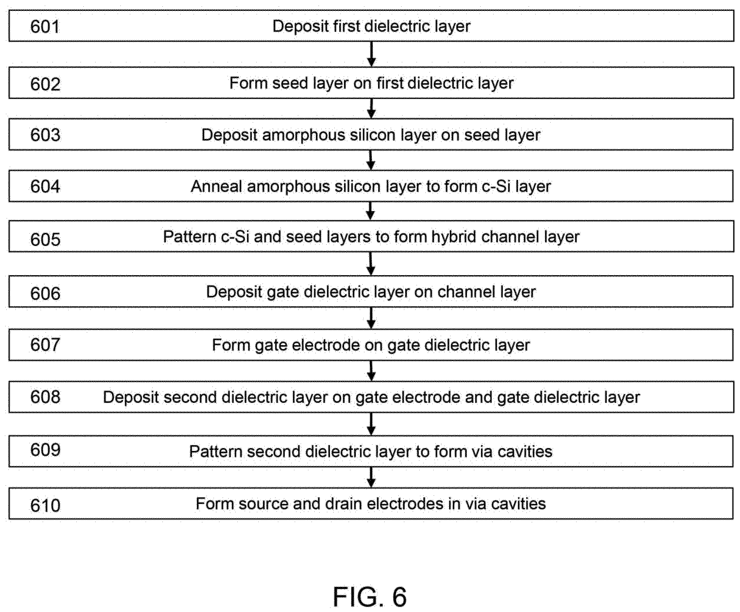

FIG. 6 is a flow diagram of a method of forming a transistor 200, according to various embodiments of the present disclosure. With reference to FIG. 6 and FIGS. 2A-2J, in step 601, a first dielectric layer 102 may be deposited a device layer (not shown). For example, the first dielectric layer 102 may be deposited on the second interconnect-level structure L2 shown in FIGS. 1A-1C.

In step 602, a seed layer 118 comprising a crystalline metal oxide semiconductor material may be formed on the first dielectric layer 102. In particular, an amorphous seed layer 118A comprising a metal oxide semiconductor material may be deposited on the first dielectric layer 102, and then the amorphous seed layer 118A may be annealed to form the seed layer 118. In the alternative, the metal oxide semiconductor material may be deposited at a temperature of greater than 100 °C, such as a temperature ranging from about 125 °C to about 400 °C, to directly form the crystalline seed layer 118.

In step 603, an amorphous silicon layer 120A may be deposited on the seed layer 118. In step 604, the amorphous silicon layer 120A may be annealed to form a c-Si layer 120. In particular, the amorphous silicon layer 120A may be heated at a temperature of about 400 °C or less to form the c-Si layer 120.

In step 605, the seed layer 118 and the c-Si layer 120 may be patterned to form a hybrid crystalline metal oxide c-Si channel layer 125. For example, the patterning may involve forming a patterned photoresist layer on the c-Si layer 120, and etching the seed layer 118 and the c-Si layer 120, using the photoresist layer as a mask.

In step 606, a gate dielectric layer 104 may be formed on the channel layer 125. For example, the gate dielectric layer 104 may be formed by depositing a high-k dielectric material, using any suitable deposition method.

In step 607, a gate electrode 110 (e.g., word line) may be formed on the gate dielectric layer 104. For example, the gate electrode 110 may be formed by depositing an electrically conductive material, and then patterning the deposited material to form the gate electrode 110.

In step 608, a second dielectric layer 106 may be deposited on the gate electrode 110 and the gate dielectric layer 104. The second dielectric layer 106 may be formed by depositing any suitable dielectric material, using any suitable deposition method.

In step 609, the second dielectric layer 106 may be patterned to form first and second via cavities 111, 113 that expose top surfaces of source and drain regions of the channel layer 125.

In step 610, source and drain electrodes 112, 114 may be formed in the via cavities 111, 113. In particular, an electrically conductive material may be deposited in the via cavities 111, 113, such the source and drain electrodes 112, 114 electrically contact the source and drain regions of the channel layer 125. Upper surfaces of the source and drain electrodes 112, 114 and the second dielectric layer 106 may be planarized, to complete the top-gate transistor 200.

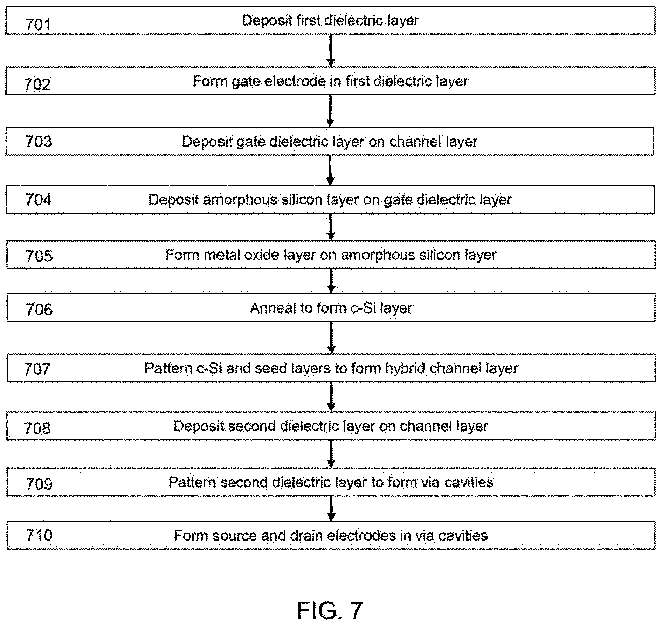

FIG. 7 is a flow diagram of a method of forming a bottom-gate (back-gate) transistor 300, 400, according to various embodiments of the present disclosure. With reference to FIG. 7 and FIGS. 3A-4C, in step 701, a first dielectric layer 102 may be deposited a device layer (not shown). For example, the first dielectric layer 102 may be deposited on the second interconnect-level structure L2 shown in FIGS. 1A-1C.

In step 702, a gate electrode 110 (e.g., word line) may be formed in the first dielectric layer 102. For example, the gate electrode 110 may be formed by depositing an electrically conductive material in a channel formed by patterning the first dielectric layer 102.

In step 703, a gate dielectric layer 104 may be formed on the gate electrode 110. For example, the gate dielectric layer 104 may be formed by depositing a high-k dielectric material on the gate electrode 110 and the first dielectric layer 102, using any suitable deposition method.

In step 704, an amorphous silicon layer 120A may be formed on the gate dielectric layer 104. The amorphous silicon layer 120A may be formed using any suitable silicon deposition method. Step 704 may include annealing the amorphous silicon layer 120A to reduce the hydrogen content of the amorphous silicon layer 120A.

In step 705, metal oxide layer may be formed on the amorphous silicon layer 120A. For example, a metal oxide semiconductor material may be deposited at a temperature below about 100 °C, to form an amorphous seed layer 118A, comprising a metal oxide semiconductor material, on the amorphous silicon layer 120A.

In the alternative, the metal oxide semiconductor material may be deposited at a temperature above about 100 °C, to form a seed layer comprising a crystalline metal oxide semiconductor material, on the amorphous silicon layer 120A.

In step 706, an annealing process may be performed to crystallize the amorphous silicon layer 120A and form a c-Si layer 120. In particular, the amorphous silicon layer 120A may be annealed at a temperature of less than about 400 °C, using the seed layer to promote crystal growth in the c-Si layer 120.

In the alternative, the annealing process may include a first step, where the amorphous seed layer 118A is crystallized, and a second step, where the amorphous silicon layer 120A is subsequently crystallized.

In step 707, the c-Si layer 120 and the seed layer 118 are patterned to form a hybrid channel layer 125. For example, the patterning may involve forming a patterned photoresist layer on the seed layer 118, and etching the seed layer 118 and the c-Si layer 120, using the photoresist layer as a mask.

In step 708, a second dielectric 106 may be formed on the channel layer 125 and the gate dielectric layer 104. The second dielectric layer 106 may be formed by depositing any suitable dielectric material, using any suitable deposition method.

In step 709, the second dielectric layer 106 may be patterned to form first and second via cavities 111, 113 that expose top surfaces of source and drain regions of the channel layer 125.

In step 710, source and drain electrodes 112, 114 may be formed in the via cavities 111, 113. In particular, an electrically conductive material may be deposited in the via cavities 111, 113, such the source and drain electrodes 112, 114 electrically contact the source and drain regions of the channel layer 125. Upper surfaces of the source and drain electrodes 112, 114 and the second dielectric layer 106 may be planarized, to complete the bottom-gate transistor 300.

In the alternative, step 710 may additionally include forming a metal layer 140 in the via cavities 111, 113, and on the second dielectric layer 106. A thermal annealing process may be performed, such as furnace heating, to oxidize the metal layer 140 and form a metal oxide layer 142. Oxygen vacancies may be generated in portions of the metal oxide layer 142 that contact the channel layer 125, thereby generating first and second conductive (N+) regions 142A, 142B in the metal oxide layer 142.

The source and drain electrodes 112, 114 may then be formed in the via cavities 111, 113, on the metal oxide layer 142. In particular, the conductive regions 142A, 142B may electrically connect the source and drain electrodes 112, 114, to the source and drain regions of the channel layer 125.

According to various embodiments, provided is front-gated (top-gate) transistor 200 fabrication method comprising: forming a seed layer 118 on a first dielectric layer 102, the seed layer 118 comprising a crystalline metal oxide semiconductor material; depositing an amorphous silicon layer 120A on the seed layer 118; annealing the amorphous silicon layer 120A to form a single-crystal silicon (c-Si) layer 120; patterning the seed layer 118 and the c-Si layer 120 to form a channel layer 125; forming a gate dielectric layer 104 on the channel layer 125; forming a gate electrode 110 on the gate dielectric layer; and forming source and drain electrodes 112, 114 that respectively electrically contact a source region and a drain region of the channel layer 125, to complete the transistor 200.

According to various embodiments, provided is a bottom-gate (back-gate) transistor 300, 400 fabrication method comprising: forming a gate electrode 110 in a first dielectric layer 102; depositing a gate dielectric layer 104 on the gate electrode 110 and the first dielectric layer 102; depositing an amorphous silicon layer 120A on the gate dielectric layer 104; forming a seed layer 118 on the amorphous silicon layer 120A, the seed layer 118 comprising a crystalline metal oxide semiconductor material; annealing the amorphous silicon layer 120A to form a single-crystal silicon (c-Si) layer 120; patterning the seed layer 118 and the c-Si layer 120 to form a channel layer 125; and forming source and drain electrodes 112, 114 on the channel layer 125 to complete the transistor 300, 400.

Various embodiments provide a transistor 300, 400 that includes a hybrid channel layer 125; a gate electrode 110 facing the hybrid channel layer 125; a gate dielectric layer 104 disposed between the gate electrode 110 and the hybrid channel layer 125; and source and drain electrodes electrically contacting source and drain regions of the hybrid channel layer 125. The hybrid channel layer 125 comprises: a single-crystal silicon (c-Si) layer 120; and a seed layer 118 contacting the c-Si layer 120 and comprising a crystalline metal oxide semiconductor material.

The various embodiments disclosed herein provide improved TFTs that may be formed in a BEOL with hybrid single-crystal silicon channel to provide TFTs with improved mobility, resistance and threshold voltage characteristics. The various embodiment TFTs may include a channel layer formed via domain matching epitaxy processes that involve the use of a metal oxide semiconductor seed layer to form a single-crystal silicon channel. By promoting a crystalline structure in the seed layer, the formation of the single-crystal silicon channel may be promoted. The embodiment devices may be formed in low temperature BEOL positions that may rival performance characteristics of FEOL MOSFETS that are fabricated at higher temperatures.

The foregoing outlines features of several embodiments so that those skilled in the art may better understand the aspects of the present disclosure. Those skilled in the art would appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure.

## Claims

1. A transistor fabrication method comprising:
forming a seed layer on a first dielectric layer, the seed layer comprising a crystalline metal oxide semiconductor material;
depositing an amorphous silicon layer on the seed layer;
annealing the amorphous silicon layer to form a single-crystal silicon (c-Si) layer;
patterning the seed layer and the c-Si layer to form a hybrid channel layer;
forming a gate dielectric layer on the hybrid channel layer;
forming a gate electrode on the gate dielectric layer; and
forming source and drain electrodes that respectively electrically contact a source region and a drain region of the hybrid channel layer.

2. The method of claim 1, wherein the forming a seed layer comprises depositing the metal oxide semiconductor material on the first dielectric layer, at a temperature of greater than 100 °C, to directly form the seed layer on the first dielectric layer.

3. The method of claim 1, wherein the forming a seed layer comprises:
depositing the metal oxide semiconductor material on the first dielectric layer, at a temperature of less than 100 °C, to form an amorphous seed layer on the first dielectric layer; and
annealing the amorphous seed layer to form the seed layer.

4. The method of claim 1, wherein the annealing the amorphous silicon layer comprises heating the amorphous silicon layer at a temperature of less than 650 °C.

5. The method of claim 1, wherein the gate dielectric layer comprises a high-k dielectric material.

6. The method of claim 1, further comprising:
forming a second dielectric layer on the gate electrode and the gate dielectric layer; and
patterning the second dielectric layer to form via cavities that expose the source and drain regions of the channel layer,
wherein the forming source and drain electrodes comprises depositing an electrically conductive material in the via cavities.

7. The method of claim 1, wherein the annealing comprises Excimer-laser annealing, flash lamp annealing, or furnace annealing.
